# EUROPÄISCHE PATENTSCHRIFT

(11) **EP 0 270 912 B1**
(45) Veröffentlichungstag und Bekanntmachung des Hinweises auf die Patenterteilung: **22.09.1993**
(21) Anmeldenummer: 87117330.8
(22) Anmeldetag: 24.11.1987
(51) Int. Cl.: H05K 7/14, H02G 3/04

(54) **Leitungskanalbord**
Cable duct
Conduit pour câblage

(30) Priorität: 27.11.1986 DE 3640454
(43) Veröffentlichungstag der Anmeldung: 15.06.1988
(73) Patentinhaber: WALDNER electronics GmbH & Co., D-82166 Gräfelfing (DE)
(72) Erfinder: Peröbner, Helmut, D-8032 Gräfelfing (DE); Sigg, Bruno, D-7988 Wangen/Allgäu (DE)
(74) Vertreter: Pohlmann, Eckart, Dipl.-Phys.

(56) Entgegenhaltungen:
- EP-A- 0 062 937
- EP-A- 0 126 924
- EP-A- 0 161 226
- FR-A- 1 103 734
- US-A- 3 307 080

## Beschreibung

Die Erfindung betrifft ein Leitungskanalbord nach dem Gattungsbegriff des Patentanspruchs 1.

Bei einem derartigen aus dem DE-GM 1 993 994 bekannten Leitungskanalbord, das u.a. für den Einsatz in Laboratorien bestimmt ist, kann durch eine entsprechende Kombination des Leitungskanales mit Geräteschienen und beispielsweise zusätzlichen Blindschienen sowie der Anordnung von mehreren Leitungskanälen jede gewünschte Anordnung und Ausbildung des Leitungskanalbordes für den jeweiligen Anwendungsfall erzielt werden.

Nach der Installation eines entsprechend zusammengestellten Leitungskanalbordes können die notwendigen Geräte über Anschlußkabel an den Anschlußplätzen angeschlossen werden, wobei eine feste Zuordnung zwischen den jeweiligen Anschlußplätzen und den zugehörigen Geräten gegeben ist. Bei dem bekannten Leitungskanalbord ist es somit notwendig, vor der Installierung die gewünschte Kombination der Bauteile zu wählen, die für den jeweiligen Anwendungsfall in Frage kommt, da eine nachträgliche Änderung der Anschlüsse zwischen den im Leitungskanal geführten Leitungen und den Anschlußplätzen nicht möglich ist.

Die der Erfindung zugrundeliegende Aufgabe besteht demgegenüber darin, das bekannte Leitungskanalbord gemäß Gattungsbegriff des Patentanspruchs 1 so auszugestalten, daß nach der Installation eine individuelle Zusammenstellung von Arbeitsplätzen aus verschiedenen Geräten bei geringem zusätzlichem Verkabelungsaufwand möglich ist.

Diese Aufgabe wird gemäß der Erfindung durch die Ausbildung gelöst, die im Kennzeichen des Patentanspruchs 1 angegeben ist.

Bei dem erfindungsgemäßen Leitungskanalbord ist es einerseits möglich, über die Arbeitsplatzleitungen die Anschlußplätze wahlweise und individuell mit den einzelnen Abgriffen der Leitungen im Leitungskanal zu verbinden, so daß eine Zuordnung der Anschlußplätze zu bestimmten Daten Steuer-und Versorgungsleitungen auch nach der Installation des Leitungskanalbordes möglich ist und somit unterschiedliche Arbeitsplätze aus verschiedenen anzuschließenden Geräten zusammengestellt werden können. Daruberhinaus ist es möglich, die Geräte der verschiedenen Arbeitsplätze auch untereinander über die Leitungen im Leitungskanal zu verbinden, so daß Daten eines Gerätes an einem Arbeitsplatz auf ein oder mehrere Geräte an einem anderen Arbeitsplatz, beispielsweise zur Weiterverarbeitung übertragen werden können. Diese Anschlüsse sind frei kombinierbar.

Besondere Ausführungsarten des erfindungsgemäßen Leitungskanalbordes sind in den Patentansprüchen 2 bis 13 angegeben.

Im folgenden wird anhand der zugehörigen Zeichnung ein besonders bevorzugtes Ausführungsbeispiel der Erfindung näher beschrieben. Es zeigen
Fig. 1 eine perspektivische Ansicht eines Grundelementes des Ausführungsbeispiels des erfindungsgemäßen Leitungskanalbordes,
Fig. 2 eine Querschnittsansicht durch den Leitungskanal bei dem Ausführungsbeispiel des erfindungsgemäßen Leitungskanalbordes,
Fig. 3 eine perspektivische Ansicht eines bevorzugten Ausführungsbeispiels des Geräteschlittens,
Fig. 4 ein weiteres bevorzugtes Ausführungsbeispiel des Geräteschlittens,
Fig. 5 schematisch die Art der Verlegung der Leitungen im Leitungskanal,
Fig. 6 den Anschluß der Gruppensammelleitungen an die Arbeitsplatzsammelleitungen,
Fig. 7 die Ausbildung der Arbeitsplatzsammelleitungen,
Fig. 8 A eine Vorderansicht sowie eine Vertikalschnittansicht einer Halteplatine für die Gruppensammelleitung und
Fig. 8 B eine Vorderansicht einer Schnittstellenplatine zur Verbindung der Gruppensammelleitung mit einer Arbeitsplatzsammelleitung.

Das in der Zeichung dargestellte Ausführungsbeispiel des erfindungsgemäßen Leitungskanalbordes umfaßt einen Leitungskanal 1, der im wesentlichen kastenförmig ausgebildet ist. Er ist an Trägerelementen 2 befestigt, die vorzugsweise Profilteile sind, die an einer Wand oder zwischen der Decke und dem Boden eines Raumes befestigbar sind, und in denen über entsprechende Beschläge an der Rückwand des Leitungskanals 1 dieser höhenverstellbar angeordnet ist.

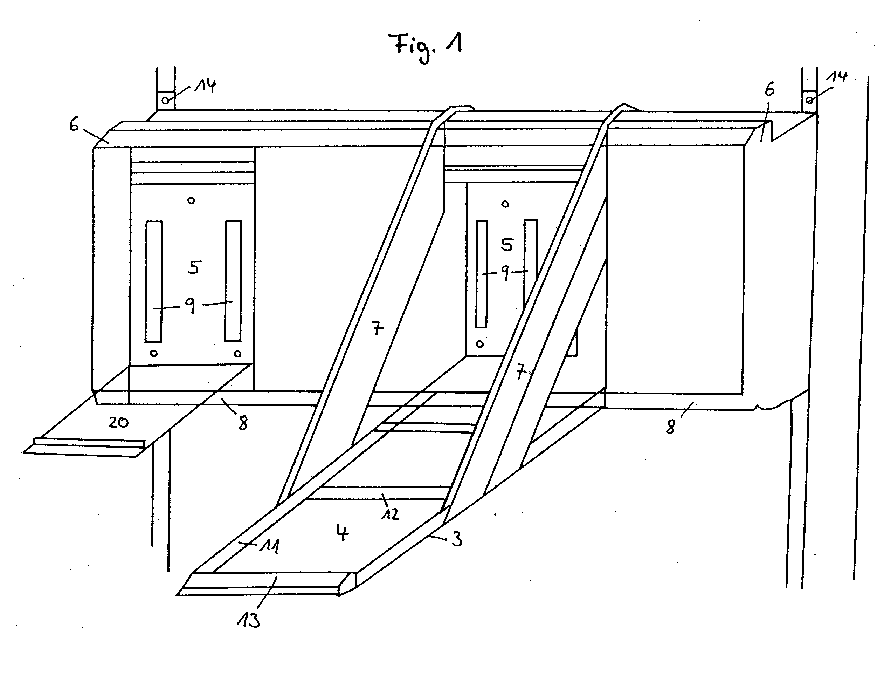

An der Vorderfront des Leitungskanals 1 ist über einen Träger 7, der am Leitungskanal 1 eingehängt ist, ein Geräteschlitten 3 mit horizontaler Bodenplatte 4 angeordnet. Wie es in Fig. 1 dargestellt ist, ist das Leitungskanalbord aus einzelnen Geräteplätzen mit einer gegebenen Grundbreite aufgebaut, an denen ein Geräteschlitten 3 jeweils angeordnet werden kann. Der Geräteschlitten 3 und der Träger 7 haben daher eine Breite, die gleich einem ganzzahligen Vielfachen der Breite der Einzelgeräteplätze des Leitungskanalbordes ist. In einem breiten Träger 7 können auch mehrere schmale Geräteschlitten 3 angeordnet werden.

Die im Leitungskanal 1 angeordneten Leitungen treten an einem oder mehreren Anschlußplätzen 5 in der Vorderfront des Leitungskanals 1 aus. Diese Leitungsaustritte können in Form von Steckern oder Kontakten 9 vorliegen, soweit es sich um Stromleitungen, Datenübertragungsleitungen oder Steuerleitungen handelt, während sie in Form von Anschlußstutzen oder Hähnen vorliegen, wenn es sich um Leitungen handelt, in denen Medien wie Flüssigkeiten oder Gase geführt werden sollen.

Wie es weiterhin in Fig. 1 dargestellt ist, ist die vordere Oberkante 6 des Leitungskanals 1 als Auflage für die Träger 7 der Geräteschlitten 3 ausgebildet.

Die Unterkante 8 der Frontseite des Leitungskanals 1 ist in entsprechender Weise als Gegenlager für Führungsschienen 11 an den Trägern 7 ausgebildet.

Das sich über die gesamte Breite des Leitungskanals 1 erstreckende Auflager in Form der vorderen Oberkante 6 erlaubt bei entsprechend angepaßter Ausbildung der Endbereiche der Träger 7 für die Geräteschlitten 3 das Einhängen und seitliche Versetzen der Geräteschlitten 3.

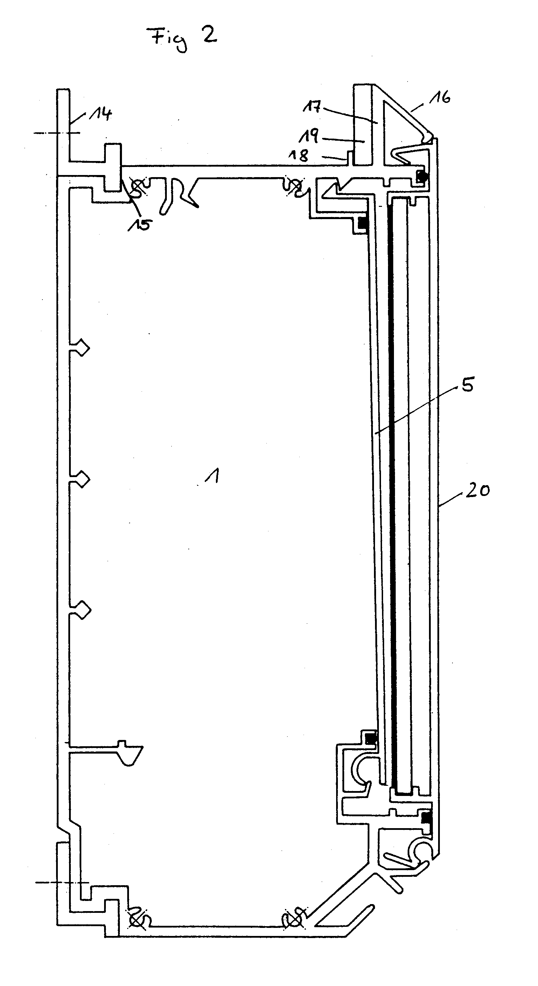

In Fig. 2 ist der Leitungskanal im Bereich eines Anschlußplatzes schematisch im Querschnitt dargestellt. Der Leitungskanal 1 ist an nicht dargestellten schienenförmigen Trägerelementen mittels Beschlägen 14 festgelegt. Diese Beschläge hinter, unter- bzw. übergreifen entsprechende Ausnehmungen 15 im Bereich der Rückwand des kastenförmigen Leitungskanals.
Diese Ausnehmungen 15 erstrecken sich kanalförmig in horizontaler Richtung, so daß der Leitungskanal 1 seitwärts zwischen die Beschläge geschoben werden kann. Das Profil an der vorderen Oberkante 6 des Leitungskanals 1, das sich ebenfalls horizontal und über die gesamte Breite des Leitungskanals 1 erstreckt, ist bei dem vorliegenden Ausführungsbeispiel halbdachförmig ausgebildet, wobei die Schräge 16 zur Auflage der Träger 7 fur die Geräteschlitten 3 dient, während der senkrechte Abschnitt 17 durch die Träger 7 für die Geräteschlitten 3 hintergriffen wird. Zur besseren Festlegung der Träger 7 bildet der untere Bereich des Abschnittes 17 mit dem sich ebenfalls horizontal erstreckenden Grat 18 einen U-förmigen Kanal 19.

Die vordere Unterkante 8 des Leitungskanals 1 ist als Gegenlager für den Endabschnitt der Führungsschienen 11 an den Trägern ausgebildet. Dieses Gegenlager erstreckt sich ebenfalls über die gesamte Breite des Leitungskanals 1. Es ist zum verriegelnden Eingriff mit den entsprechend ausgeformten Endabschnitten der Führungsschienen 11 der Geräteschlitten 3 ausgebildet.

Der Anschlußplatz 5 mit Steckern, Kontakten und/oder Leitungsausgängen 9 ist durch eine Verriegelungsklappe 20 verschließbar, die zum Anschluß eines Gerätes abnehmbar oder abklappbar ist.

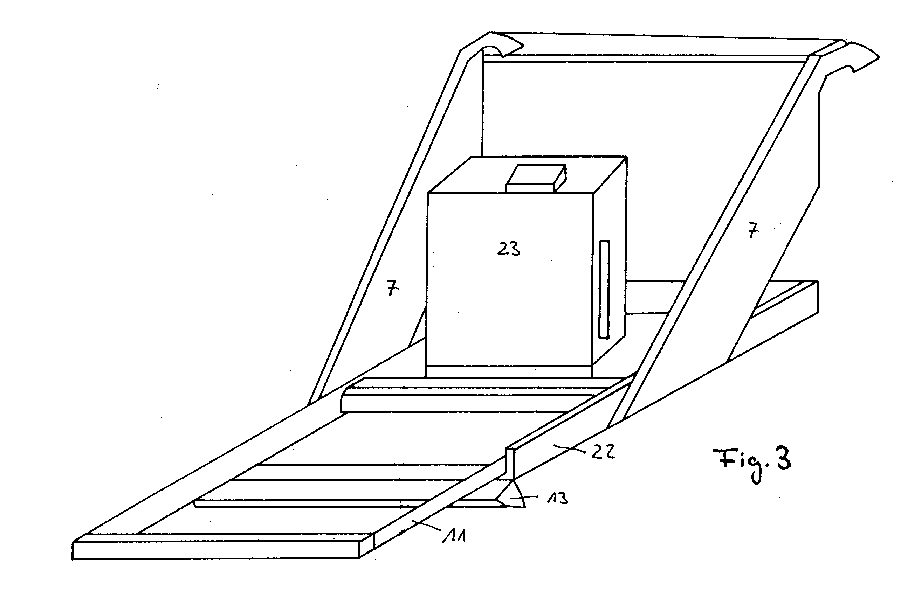

In Fig. 3 ist in einer perspektivischen Ansicht ein bevorzugtes Ausführungsbeispiel des Geräteschlittens 3 gezeigt. Die Schienen 11 an den Trägern 7 sind bei diesem Ausführungsbeispiel teleskopartig in den Schlitten und Rahmen einschiebbar. Eine abklappbare und abschließbare Traverse 13 erlaubt die Sicherung des auf den Schienen 11 aufgeschobenen Gerätes. Die Träger 7 für die Geräteschlitten 3 sind im oberen Endabschnitt im wesentlichen hakenförmig zum Hintergreifen und Aufliegen auf der in beschriebener Weise ausgebildeten Oberkante 6 des Leitungskanals 1 ausgebildet.

Am hinteren Teil des Geräteschlittens 3 befindet sich ein Adapter 23, der an seiner Rückseite mit Steckern und/oder Leitungsausgängen versehen ist, die an der Rückwand so definiert angeordnet sind, daß sie zum Einschub in die Anschlußplätze 5 geeignet sind. An der Vorderseite des Adapters sind entsprechende Leitungsstecker oder Leitungsausgänge ausgebildet, die mit den Leitungssteckern oder Leitungsausgängen an der Rückwand verbunden sind und an die Geräte angeschlossen werden können, die am vorderen Bereich des Geräteschlittens 3 angeordnet sind, um diese Geräte beispielsweise mit Steuerdaten und Medien zu versorgen oder Ausgangsdaten dieser Geräte abzuleiten.

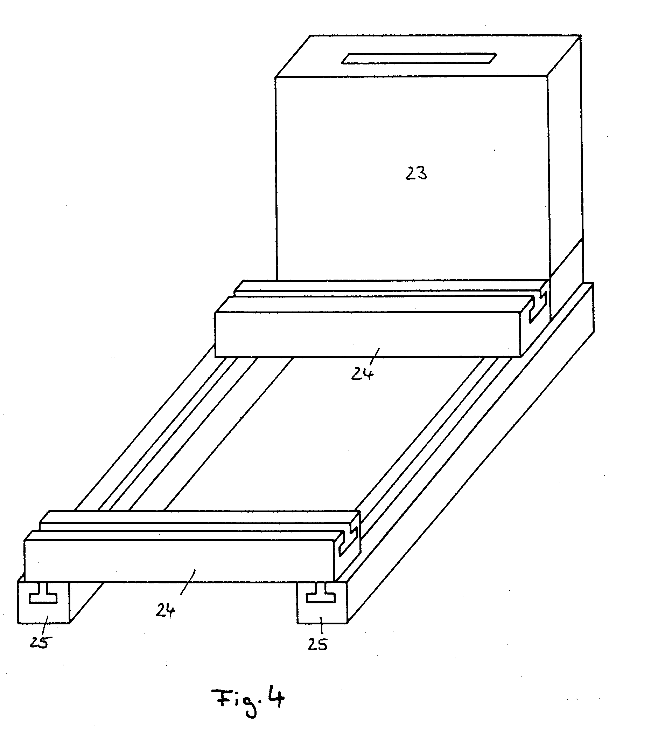

Wie es in Fig. 4 dargestellt ist, weist ein besonders bevorzugtes Ausführungsbeispiel des Geräteschlittens einen palettenartigen Einschub auf, der zwei senkrecht auf den Leitungskanal 1 zu verlaufende Schienen 25 und, diese rechtwinklig überbrückend, zwei weitere schienenförmige Bauteile 24 aufweist. Auf diese Weise ist die Spurbreite der jeweiligen Schienenpaare veränderlich. Die auf dem Schienenpaar 24 angeordneten Geräte sind durch den Aufbau des palettenartigen Einschubs sowohl senkrecht auf den Leitungskanal 1 zu als auch parallel zu letzterem verstellbar. Im Bereich der Vorderfront des Leitungskanals ist der Adapter 23 auf dem Schienenpaar 25 angeordnet.

Zwischen die Schienen 11 an den Trägern 7 ist nach dem Herunterklappen der Traverse 13 ein Schlitten mit einem anzuschließenden Gerät einschiebbar, der aus einem Bodenblech besteht, auf dem der Adapter in Form eines Winkelteils angeordnet ist. Der Adapter ist vorzugsweise mit einem Schutzdeckel abdeckbar.

Die Anordnung eines anzuschließenden Gerätes am Leitungskanalbord erfolgt in der Weise, daß das Gerät zunächst auf dem zwischen die Schienen 11 einschiebbaren Schlitten angeordnet und mit den Anschluß- und Steckerverbindungen an der Vorderseite des Adapters 23 verbunden wird. Der Adapter 23 wird dann mit dem Schutzdeckel verschlossen. Die somit gebildete Baueinheit aus Schlitten, Adapter und Gerät wird zwischen die Schienen 11 eingeschoben und über die Anschlüsse an der Rückseite des Adapters 23 beim Einschieben mit den Steckern 9 des Leitungskanals 1 verbunden. Dieser Anschluß erfolgt somit kabellos, so daß nur eine Kabelverbindung zwischen dem Gerät und den Anschlüssen an der Vorderseite des Adapters 23 besteht. Nach dem Einschub des Schlittens zwischen den Schienen 11 und der dabei erfolgenden Verbindung des Gerätes über den Adapter 23 mit den Steckern 9 des Leitungskanals 1 wird die Traverse 13 wieder hochgeklappt, um das zwischen den Schienen 11 auf dem Schlitten befindliche Gerät zu sichern.

Bei einem Gerätewechsel oder einer Umordnung der jeweiligen Arbeitsplätze kann der gesamte Block aus dem Schlitten, dem Gerät mit Adapter und Steckerplatte sowie ggfs. einer später zu beschreibenden Kodierungs- oder Schnittstellenplatine an einen anderen Geräteplatz ohne weitere Anpassungen umgesetzt werden.

In dieser Weise ist es möglich, individuell Arbeitsplätze aus mehreren Geräteplätzen mit verschiederen Geräten zusammenzustellen und je nach Bedarf umzubauen.

Wie es in Fig. 5 dargestellt ist, sind die Anschlußplätze 5 mit den Steckern 9 an der Frontseite des Leitungskanals 1 durch einzelne Übergabekabel 26 mit einer Arbeitsplatzsammelleitung 27 verbunden, die mit Abgriffen 35 in regelmäßigen Abständen versehen ist. Diese Arbeitsplatzsammelleitung 27, die vorzugsweise aus einem Flachbandkabel mit einer Vielzahl von Adern und einer entsprechenden Anzahl von Abgriffbuchsen in regelmäßigen Abständen besteht, ist über einen weiteren Abgriff 34 mit der Gruppensammelleitung 28 verbunden. Die Gruppensammelleitung 28 sowie die Arbeitsplatzsammelleitung 27 sind im Leitungskanal verlegt.

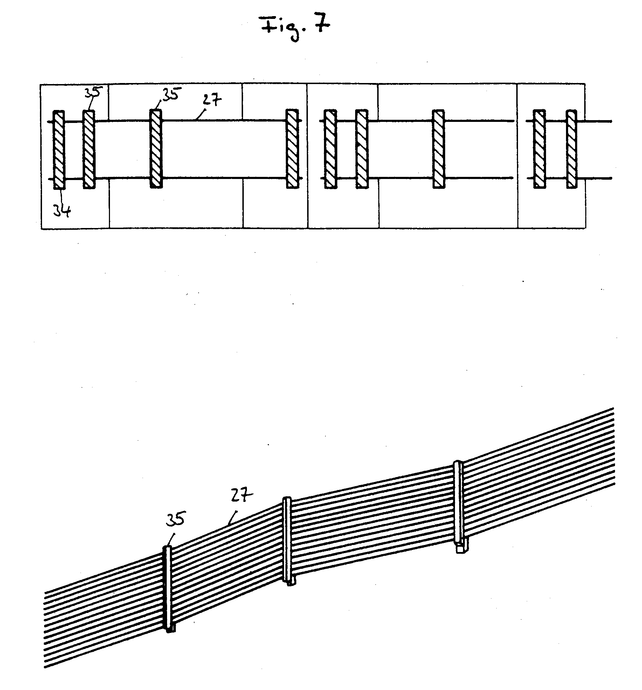

In Fig. 7 sind die Arbeitsplatzsammelleitungen 27 für 2 Arbeitsplätze jeweils dargestellt. Wie es in Fig. 7 dargestellt ist, sind die Arbeitsplatzsammelleitungen über die Abgriffe 34 mit der Gruppensammelleitung 28 verbunden und in regelmäßigen Abständen mit Abgriffen 35 in Form von Buchsen zum Anschluß an die Anschlußplätze 5 an der Frontseite versehen. Bei dem dargestellten Ausführungsbeispiel können somit 3 Geräteplätze an eine Arbeitsplatzsammelleitung 27 angeschlossen werden, wobei der mittlere Geräteplatz die doppelte Breite des Grundelementes hat.

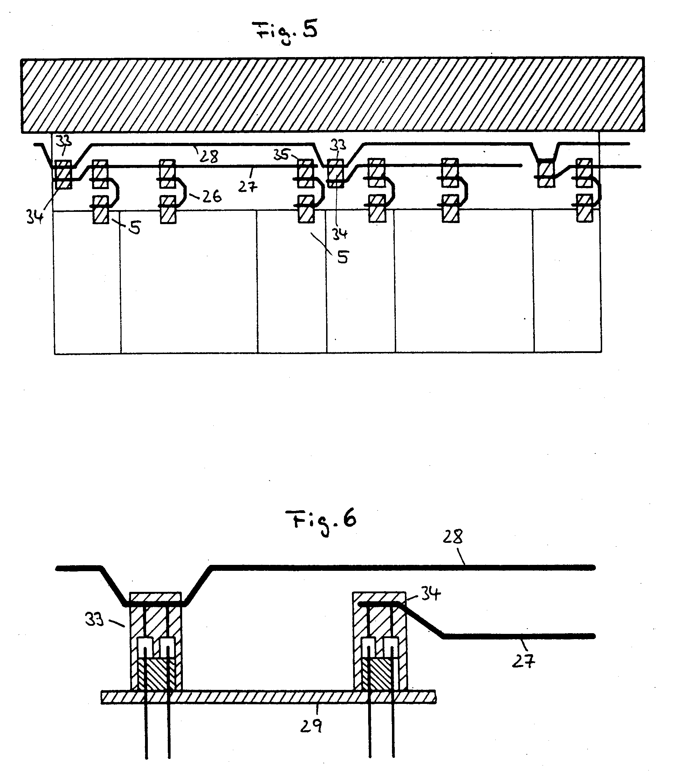

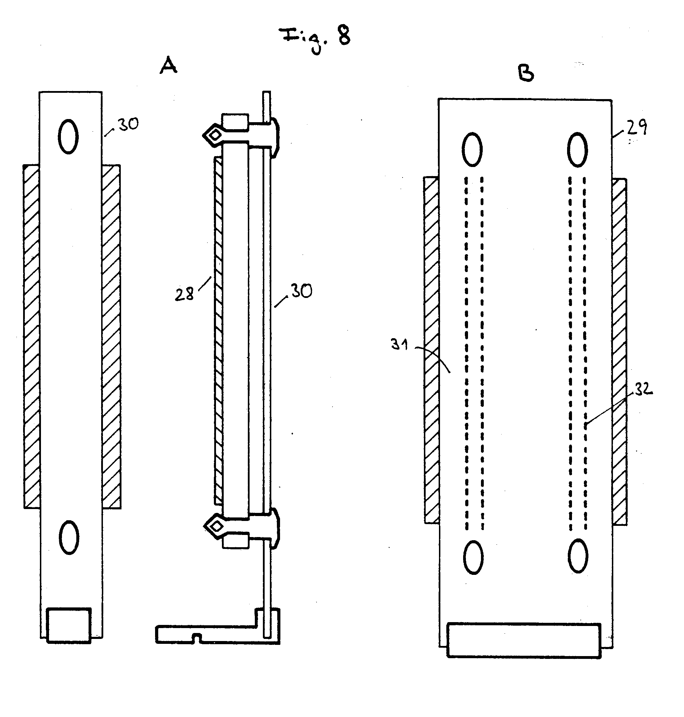

Wie es in Fig. 6 dargestellt ist, kann vorzugsweise zwischen der Gruppensammelleitung 28 und der Arbeitsplatzsammelleitung 27 eine Schnittstellenplatine 29 vorgesehen sein, die an ihrer Vorderseite und Rückseite mit jeweiligen Anschlüssen, beispielsweise in Form von Kontakten oder Kontaktstiften in einer Anzahl versehen ist, die der Anzahl der Adern der Sammelleitungen jeweils entspricht. Eine Vorderansicht dieser Platine ist in Fig. 8B dargestellt. Die Abgriffe 33 der Gruppensammelleitung 28 sind mit einer Reihe von Anschlüssen an der Rückseite der Platine 29 verbunden, während die Anschlüsse 34 der Arbeitsplatzsammelleitung 27 zum Anschluß an die Gruppensammelleitung 28 mit der anderen Reihe von Anschlüsse an der Rückseite der Platine 29 verbunden sind. Durch eine entsprechende Verbindung der Anschlußstifte oder Anschlußkontakte 31 und 32 an der Vorderseite der Platine, die als Kodierungsplatte wirkt, ist es dann möglich, die Zuordnung zwischen den Steckern 9 an den Anschlußplätzen 5 an der Frontseite des Leitungskanales 1 zu den entsprechenden Adern der Gruppensammelleitung 28 zu ändern, so daß beispielsweise die Datenausgangsleitung eines Gerätes an einem Arbeitsplatz zur Dateneingangsleitung eines anderen Gerätes an einem anderen Platz gemacht werden kann.

Vorzugsweise ist die Steckerplatte mit den Steckern 9 am Anschlußplatz 5 an der Vorderseite des Leitungskanals 1 herausnehmbar ausgebildet, so daß nach Öffnen des Deckels 20 an jedem Geräteplatz eine Steckerplatte einsetzbar und durch Übergabekabel 26 mit der Arbeitsplatzsammelleitung 27 verbunden werden kann.

Die elektrische Stromversorgungsleitungen, beispielsweise die üblichen Netzversorgungsleitungen mit einer Spannung von 220 Volt können außerhalb des Kanalbordes und direkt unter dem Bord verlegt und in regelmäßigen Abständen mit Anschlüssen versehen sein, um die auf den Geräteschlitten angeordneten Geräte an die Stromversorgung anzuschließen. Gleiches gilt für Versorgungsleitungen für flüssige und gasförmige Medien, die gleichfalls unter dem Kanalbord angeordnet und mit in regelmäßigen Abständen vorgesehenen Zapfeinrichtungen versehen sein können.

Im Innenraum des Kanalbordes, dort wo die Sammelleitungen verlegt sind, können weiterhin elektronische Einrichtungen, beispielsweise Steuereinrichtungen, Verstärkereinrichtungen, Treibereinrichtungen, Signalverarbeitungseinrichtungen, beispielsweise in Form von integrierten Schaltungen auf weiteren Platinen, vorgesehen sein, die dazu dienen, die über die Sammelleitungen gehenden Daten zu verarbeiten, die angeschlossenen Geräte zu steuern, sowie die Ausgangssignale der einzelnen Geräte zusäzlich zu verstärker.

Um ein Eindringen von Fremd- oder Schadstoffen in das Innere des Leitungskanalbordes zu vermeiden, ist es zweckmäßig, den Innenraum des Leitungskanalbordes unter einen Überdruck bezüglich des außen herrschenden Druckes zu setzen. Über einen geeigneten Schlauchanschluß am Kanalbord kann dann auch das Innere der auf den Geräteschlitten angeordneten Geräte auf den entsprechenden Überdruck gesetzt werden, um auch ein Eindringen von Fremdstoffen in die Geräte zu vermeiden. Dazu reicht es aus, am Kanalbord und am Gerät einen entsprechenden Schlauchansatzstutzen vorzusehen, und beide Stutzen über ein Schlauchstück miteinander zu verbinden.

Im Inneren des Leitungskanalbordes können weitere Leitungen, beispielsweise in der Nähe der oberen Abschlußwand, längs des Leitungskanalbordes verlegt sein, die beispielsweise Sammelleitungen von elektronischen Datenverarbeitungsanlagen usw. darstellen. An der Steckerplatte der Anschlußplätze 5 in Fig. 1 mit den Steckeranschlüssen 9 können Anzeigeelemente vorgesehen sein, die beispielsweise Kontrolleuchten, Meßinstrumentanzeigen usw. umfassen. Die Steckerplatte kann somit in Form eines Steuerpultes ausgebildet sein, das verschiedene nformationen über die Funktion der angeschlossenen Geräte sowie Angaben über die gewonnenen Meßergebnisse liefert. Um die Kontakte einer nicht benutzten Steckerplatte vor einer Korrosion zu schützen, kann die Verriegelungsplatte 20 mit Dichtungen versehen sein, die die Steckerplatte gegenüber der Außenumgebung dicht abschließt.

Die Geräteschlitten 3 können mit einer Schutzhaube versehen sein, um beispielsweise bei chemischen Versuchsanordnungen entstehende Gase über einen an der Schutzhaube vorgesehenen Anschlußstutzen abzusaugen. Für die Anordnung von Geräten, Kolonnen, Schlauchleitungen, Klemmen usw. zum Aufbau einer derartigen Versuchsanordnung können an den Seitenarmen der Träger 7 geeignete Befestigungseinrichtungen vorgesehen sein.

## Patentansprüche

1. Leitungskanalbord aus einem kastenförmigen Leitungskanal, in dem Steuer-, Daten- und/oder Versorgungsleitungen fur anzuschließende Geräte gefuhrt sind, die an der Frontseite des Leitungskanals an Anschlußplätzen austreten, **gekennzeichnet** durch Geräteschlitten (3), die an der Frontseite des Leitungskanals (1) in horizontaler Richtung versetzbar angeordnet sind und eine zur Frontseite horizontale Bodenplatte (4) aufweisen, wobei die Leitungen im Leitungskanal in regelmäßigen Abständen mit Abgriffen versehen sind, die uber Arbeitsplatzleitungen mit den Anschlußplätzen (5) an der Frontseite verbindbar sind.

2. Leitungskanalbord nach Anspruch 1, **gekennzeichnet** durch wenigstens ein in vertikaler Richtung verlaufendes Trägerelement (2), an dem der Leitungskanal (1) höhenverstellbar angeordnet ist.

3. Leitungskanalbord nach Anspruch 1 oder 2, dadurch **gekennzeichnet,** daß der Leitungskanal (1) in horizontaler Richtung an seiner vorderen Oberkante (6) in Form eines Profilteils zum Einhängen von Trägern (7) für die Geräteschlitten (3) ausgebildet ist.

4. Leitungskanalbord nach Anspruch 3, dadurch **gekennzeichnet,** daß das Profilteil zur Aufnahme der Träger (7) für die Geräteschlitten (3) in Form eines Grates an der vorderen Oberkante (6) des Leitungskanals (1) ausgebildet ist, wobei der Grat durch die Träger (7) hinter- bzw. untergreifbar ausgebildet ist und das Einhänglager für die Träger (7) bildet.

5. Leitungskanalbord nach einem der vorhergehenden Ansprüche, dadurch **gekennzeichnet,** daß entlang der vorderen Unterkante (8) des Leitungskanals (1) ein Gegenlager zur Aufnahme der leitungskanalseitigen Endabschnitte der Geräteschlitten (3) ausgebildet ist.

6. Leitungskanalbord nach einem der vorhergehenden Ansprüche, dadurch **gekennzeichnet,** daß die innerhalb des Leitungskanals (1) geführten Leitungen aus seiner Frontseite an Anschlußplätzen (5) in Form von Steckern oder Öffnungen mit räumlich genau definierter Lage austreten.

7. Leitungskanalbord nach einem der vorhergehenden Ansprüche, dadurch **gekennzeichnet,** daß die Bodenplatte (4) der Geräteschlitten (3) von den Trägern (7) gehalten ist, wobei die freien Endabschnitte der Träger (7) zum Einhängen in das Profilteil und die Endbereiche der Bodenplatte (4) zum Eingriff in das horizontal verlaufende Gegenlager an der Unterkante (8) des Leitungskanals (1) ausgebildet sind.

8. Leitungskanalbord nach Anspruch 7, dadurch **gekennzeichnet,** daß die Träger (7) Schienenelemente (11) aufweisen, die im eingehängten Zustand der Geräteschlitten (3) im wesentlichen horizontal und senkrecht auf die Frontseite des Leitungskanals (1) zuverlaufen und durch sprossenartige Abstandshalter (12) miteinander verbunden sind.

9. Leitungskanalbord nach Anspruch 8, dadurch **gekennzeichnet,** daß an der Vorderseite der Schienenelemente (11) eine abklappbare Traverse (13) vorgesehen ist, die unter die Höhe der Bodenplatte (4) abklappbar und über die Höhe der Bodenplatte (4) hochklappbar ist.

10. Leitungskanalbord nach Anspruch 8, dadurch **gekennzeichnet,** daß die Schienenelemente (11) mehrteilig und teleskopartig ineinanderschiebbar ausgebildet sind.

11. Leitungskanalbord nach einem der vorhergehenden Ansprüche, **gekennzeichnet** durch Arbeitsplatzsammelleitungen (27) im Leitungskanal (1), die an mehreren Anschlußplätzen (5) entlang verlegt sind und mit den Abgriffen (33) von Gruppensammelleitungen (28) im Leitungskanal (1) verbunden sind, die über die gesamte Länge des Leitungskanals (1) verlaufen und in regelmäßigen Abständen mit derartigen Abgriffen (33) versehen sind, wobei an den Arbeitsplatzsammelleitungen (27) in regelmäßigen Abständen weitere Abgriffe (35) vorgesehen sind, die mit den Anschlußplätzen (5) an der Frontseite des Leitungskanals (1) verbunden sind.

12. Leitungskanalbord nach Anspruch 11, **gekennzeichnet** durch Schnittstellenplatinen (29), die an ihrer Rückseite Anschlüsse, die mit der Gruppensammelleitung (28) verbunden sind, und Anschlüsse, die mit der Arbeitsplatzsammelleitung (27) verbunden sind, und an ihrer Vorderseite mit diesen Anschlüssen verbundene entsprechende Anschlußelemente aufweisen, die kreuzweise miteinander verbunden werden können.

13. Leitungskanalbord nach einem der vorhergehenden Ansprüche, dadurch **gekennzeichnet,** daß an dem leitungskanalseitigen Ende der Geräteschlitten (3) ein Adapter (23) in Form einer senkrechten Platte mit je einer Anschlußleiste an der Vorder- und an der Rückseite vorgesehen ist, deren Anschlüsse über die Adapterplatte miteinander verbunden sind, wobei die Anschlüsse an der Rückseite der Adapterplatte räumlich so angeordnet sind, daß sie räumlich zu den Anschlüssen (9) an der Frontseite des Leitungskanals (1) passen.

## Claims

1. Cable duct board consisting of a box-like cable duct in which control, data and/or supply cables are guided for apparatus which are to be connected, which cables emerge at connection points at the front of the cable duct, characterised by apparatus slides (3) which are disposed at the front of the cable duct (1) such that they can be displaced horizontally and which comprise a base plate (4) which is horizontal relative to the front, the cables in the cable duct being provided at regular intervals with taps which can be connected to the connection points (5) at the front via work place cables.

2. Cable duct board according to Claim 1, characterised by at least one carrier element (2) which extends in the vertical direction and on which the cable duct (1) is disposed such that it can be adjusted vertically.

3. Cable duct board according to Claim 1 or 2, characterised in that the cable duct (1) in the horizontal direction at its front upper edge (6) is in the form of a profiled part for the suspension of carriers (7) for the apparatus slides (3).

4. Cable duct board according to Claim 3, characterised in that the profiled part for accommodating the carriers (7) for the apparatus slides (3) is in the form of a ridge on the front upper edge (6) of the cable duct (1), the ridge being formed such that the carriers (7) can engage behind or below it and forms the suspension bearing for the carriers (7).

5. Cable duct board according to any one of the preceding claims, characterised in that a counter bearing for accommodating the end sections, of the apparatus slides (3), at the cable duct end is formed along the front lower edge (8) of the cable duct (1).

6. Cable duct board according to any one of the preceding claims, characterised in that the cables guided inside the cable duct (1) emerge from the front thereof at connection points (5) in the form of plugs or openings with a position defined precisely in spatial terms.

7. Cable duct board according to any one of the preceding claims, characterised in that the base plate (4) of the apparatus slides (3) is retained by the carriers (7), the free end sections of the carriers (7) being adapted for suspension in the profiled part and the end regions of the base plate (4) being adapted for engagement in the horizontal counter bearing at the lower edge (8) of the cable duct (1).

8. Cable duct board according to Claim 7, characterised in that the carriers (7) comprise rail components (11) which, in the suspended state of the apparatus slides (3), run substantially horizontally and vertically towards the front of the cable duct (1) and are connected to one another by spoke-like spacers (12).

9. Cable duct board according to Claim 8, characterised in that a hinged cross member (13), which can be folded down below the level of the base plate (4) and folded up above the level of the base plate (4), is provided at the front of the rail components (11).

10. Cable duct board according to Claim 8, characterised in that the rail components (11) are formed in a number of parts and can be inserted into one another telescopically.

11. Cable duct board according to any one of the preceding claims, characterised by work place power lines (27) in the cable duct (1) which are laid along a plurality of connection points (5) and are connected to the taps (33) of group power lines (26) in the cable duct (1), which group power lines extend over the entire length of the cable duct (1) and are provided at regular intervals with taps (33) of this type, further taps (35), which are connected to the connection points (5) at the front of the cable duct (1), being provided at regular intervals on the work place power lines (27).

12. Cable duct board according to Claim 11, characterised by interface cards (29) which comprise, at their rear, connections which are connected to the group power line (28) and connections which are connected to the work place power line (27) and, at their front, corresponding connection components which are connected to these connections and which can be connected to one another in a crosswise manner.

13. Cable duct board according to any one of the preceding claims, characterised in that an adapter (23) in the form of a vertical plate, which has one connection strip at the front and at the rear in each case and of which the connections are connected to one another via the adapter plate, is provided at the end of the apparatus slides (3) at the cable duct end, the connections at the rear of the adapter plate being disposed spatially in such a way that they are adapted spatially to the connections (9) at the front of the cable duct (1).

## Revendications

1. Unité formant conduit à câbles, constitué par un conduit à câbles en forme de boîte, dans lequel s'étendent des lignes de commande, de transmission de données et/ou d'alimentation prévues pour des appareils devant être raccordés et qui ressortent au niveau de la face avant du conduit à câbles, en des emplacements de raccordement, caractérisée par des coulisseaux (3) de support d'appareils, qui sont disposés sur la face avant du conduit à câbles (1), de manière à être déplaçables dans la direction horizontale et possèdent une plaque de base horizontale (4) perpendiculaire à la face avant, les lignes situées dans le conduit à câbles étant équipées, à des intervalles réguliers, de prises qui peuvent être réunies par l'intermédiaire de conducteurs reliés à des postes de travail, aux emplacements de raccordement (5) situés sur la face avant.

2. Unité formant conduit à câbles selon la revendication 1, caractérisée par au moins un élément de support (2) qui s'étend verticalement et sur lequel le conduit à câbles (1) est monté.

3. Unité formant conduit à câbles selon la revendication 1 ou 2, caractérisée en ce que le conduit à câbles (1) possède au niveau de son arête supérieure avant (6), dans la direction horizontale, la forme d'un élément profilé permettant l'accrochage de supports (7) pour les coulisseaux (3) de support d'appareils.

4. Unité formant conduit à câbles selon la revendication 3, caractérisée en ce que l'élément profilé servant à loger les supports (7) pour les coulisseaux (3) de support d'appareils est agencé sous la forme d'un rebord sur l'arête supérieure avant (6) du conduit à câbles (1), le rebord étant agencé de manière que les supports (7) puissent s'engager derrière ou au-dessous de ce rebord, et constituant le support d'accrochage pour les supports (7).

5. Unité formant conduit à câbles selon l'une des revendications précédentes, caractérisée en ce qu'un support antagoniste servant à loger les sections d'extrémité, tournées du côté du conduit à câbles, des coulisseaux (3) de support d'appareils est formé le long de l'arête inférieure avant (8) du conduit à câbles (1).

6. Unité formant conduit à câbles selon l'une des revendications précédentes, caractérisée en ce que les lignes, qui s'étendent à l'intérieur du conduit à câbles (1), ressortent de sa face avant au niveau d'emplacements de raccordement (5), sous la forme de connecteurs ou d'ouvertures ayant une position définie de façon précise dans l'espace.

7. Unité formant conduit à câbles selon l'une des revendications précédentes, caractérisée en ce que la plaque de base (4) des coulisseaux (3) de support d'appareils est maintenue par les supports (7), les sections d'extrémité libres des supports (7) étant agencées de manière à s'accrocher dans l'élément profilé, tandis que les zones d'extrémité de la plaque de base (4) sont agencées de manière à s'engager dans le support antagoniste horizontal au niveau de l'arête inférieure (8) du conduit à câbles (1).

8. Unité formant conduit à câbles selon la revendication 7, caractérisée en ce que les supports (7) possèdent des éléments en forme de rails (11), qui, lorsque les coulisseaux (3) de support d'appareils sont à l'état accrochés, sont sensiblement horizontaux et perpendiculaires à la face avant du conduit à câbles (1) et sont reliés entre eux par des entretoises (12) en forme de barreaux.

9. Unité formant conduit à câbles selon la revendication 8, caractérisée en ce que sur la face avant des éléments en forme de rails (11) est prévue une traverse rabattable (13), qui peut être rabattue au-dessous du niveau en hauteur de la plaque de base (4) et peut être soulevée par rabattement au-dessus du niveau en hauteur de la plaque de base (4).

10. Unité formant conduit à câbles selon la revendication 8, caractérisée en ce que les éléments en forme de rails (11) sont formés de plusieurs éléments et peuvent être insérés les uns dans les autres de façon télescopique.

11. Unité formant conduit à câbles selon l'une des revendications précédentes, caractérisée par des lignes collectrices (27) de raccordement à des postes de travail, situées dans le conduit à câbles (1) et qui sont installées selon plusieurs postes de raccordement (5) et sont raccordées aux prises (33) de lignes collectrices de groupe (28), qui sont situées dans le conduit à câbles (1) et s'étendent sur toute la longueur du conduit à câbles (1) et doivent être équipées de prises de ce type (33) à des intervalles réguliers, auquel cas dans d'autres lignes collectrices (29) raccordées à des espaces de travail, il est prévu, à des intervalles réguliers, d'autres prismes (35) qui sont raccordés aux postes de raccordement (5) sur la face avant du conduit à câbles (1).

12. Unité formant conduit à câbles selon la revendication 11, caractérisée par des platines d'interface (29), qui comportent au niveau de leur face arrière, des bornes, qui sont raccordées à la ligne collectrice de groupe (28), et des bornes, qui sont raccordées à la ligne collectrice (27) raccordée aux postes de travail, et, sur leur face avant, des éléments de raccordement correspondants, qui sont raccordés à ces bornes et peuvent être reliés entre eux d'une manière croisée.

13. Unité formant conduit à câbles selon l'une des revendications précédentes, caractérisée en ce que sur l'extrémité, tournée vers le conduit à câbles, des coulisseaux (3) de support d'appareils, il est prévu un adaptateur (23) réalisé sous la forme d'une plaque verticale comportant respectivement une barrette de connexions sur sa face avant et sur sa face arrière et dont les bornes sont reliées entre elles par l'intermédiaire de la plaque formant adaptateur, les bornes situées sur la face arrière de la plaque formant adaptateur étant disposées dans l'espace de telle sorte qu'elles s'adaptent dans l'espace aux bornes (9) situées sur la face avant du conduit à câbles.
